# EUROPEAN PATENT APPLICATION

(11) **EP 2 562 837 A1**
(43) Date of publication of application: **27.02.2013**
(21) Application number: 11771971.6
(22) Date of filing: 18.04.2011
(51) Int. Cl.: H01L 41/113, B81B 7/02, G01J 1/02, H01L 41/08, H01L 41/18, H01L 41/22, H01L 41/24, G01P 15/09

(54) **FERROELECTRIC DEVICE**

(30) Priority: 21.04.2010 JP 2010098204
(71) Applicant: Panasonic Corporation, Kadoma-shi Osaka 571-8501 (JP)
(72) Inventor: OGAWA, Junya, Osaka 540-6207 (JP); YAMAUCHI, Norihiro, Osaka 540-6207 (JP); MATSUSHIMA, Tomoaki, Osaka 540-6207 (JP); AIZAWA, Koichi, Osaka 540-6207 (JP)
(74) Representative: Appelt, Christian W.
(86) International application number: PCT/JP2011/059521
(87) International publication number: WO 2011/132636

(57) **Abstract**

A ferroelectric device comprises: a silicon substrate (a first substrate) 10; a lower electrode (a first electrode) 14a formed on one surface side of first substrate 10; a ferroelectric film 14b formed on a surface of lower electrode 14a opposite to first substrate 10 side; and an upper electrode (a second electrode) 14c formed on a surface of ferroelectric film 14b opposite to lower electrode 14a side. The ferroelectric film 14b is formed of a ferroelectric material with a lattice constant difference from silicon. The ferroelectric device further comprises a shock absorbing layer 14d formed of a material with better lattice matching with ferroelectric film 14b than silicon and provided directly below the lower electrode 14a. The first substrate 10 is provided with a cavity 10a that exposes a surface of shock absorbing layer 14d opposite to lower electrode 14a side.

## Description

### TECHNICAL FIELD

The invention relates generally to ferroelectric devices and, more particularly, to a ferroelectric device that uses a piezoelectric effect or a pyroelectric effect of a ferroelectric film.

### BACKGROUND ART

Conventionally, ferroelectric devices that use a piezoelectric effect or a pyroelectric effect of a ferroelectric film have been attracting attention.

As an example of a ferroelectric device of this type, a MEMS (micro electro mechanical systems) device, that comprises a functional portion having a ferroelectric film in one surface side of a silicon substrate, has been proposed, from the viewpoint of the cost reduction, the mechanical strength and the like. As a MEMS device of this type, for example, a power generating device (for example, see R. van Schaijk, et al, "Piezoelectric AIN energy harvesters for wireless autonomoustransducer solutions", IEEE SENSORS 2008 Conference,2008, page 45-48) or an actuator that uses a piezoelectric effect of a ferroelectric film, and a pyroelectric device, such as a pyroelectric infrared sensor, that uses a pyroelectric effect of a ferroelectric film (for example, see Japanese Patent Application Laid-Open No. 8-321640) have been researched and developed at various facilities. In addition, as a ferroelectric material that exhibits both of the piezoelectric effect and the pyroelectric effect, for example, PZT(:Pb(Zr,Ti)03) or the like that is a type of a lead-based oxide ferroelectric has been known widely.

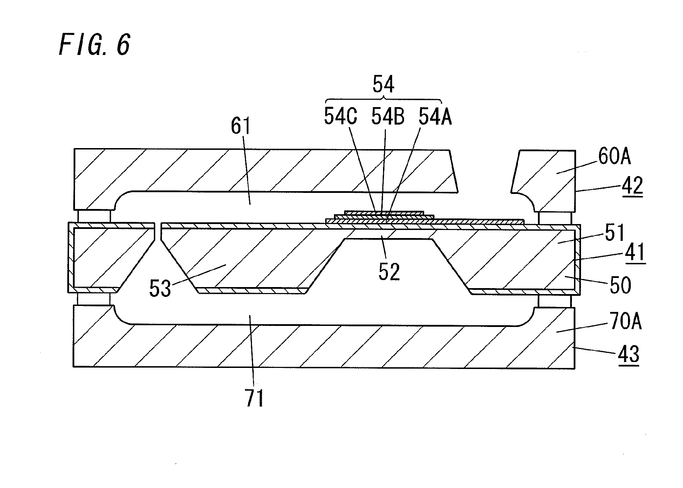

As shown in Fig. 6, the power generating device disclosed in the document of R. van Schaijk comprises a main unit 41 formed by using a silicon substrate 50. The main unit 41 comprises a frame portion 51, a cantilever (a beam) 52 that is disposed within the frame portion 51 and is swingably supported by the frame portion 51, and a weight portion 53 that is disposed at a tip of the cantilever 52. Then, a functional portion 54, which comprises a power generating portion for generating AC voltage in response to the swing of the cantilever 52, is provided in the cantilever 52 of the main unit 41.

The functional portion 54 comprises a lower electrode 54A formed of a Pt film, a ferroelectric film (a piezoelectric membrane) 54B that is formed of an AIN thin film or a PZT thin film and is provided on one surface side of the lower electrode 54A opposite to the cantilever 52 side, and an upper electrode 54C that is formed of an Al film and is provided on one surface side of the ferroelectric film 54B opposite to the lower electrode 54A side.

Further, in the document of R. van Schaijk, as a material of the piezoelectric membrane being the ferroelectric film 54B, the adoption of a piezoelectric material having a small relative permittivity and a large piezoelectric constant e₃₁ has been proposed, in order to improve the output of the power generating device.

Moreover, the power generating device comprises a first cover substrate 42 that is formed by using a first glass substrate 60A and a second cover substrate 43 that is formed by using a second glass substrate 70A. Then, in one surface side (an upper side in Fig. 6) of the main unit 41, the frame portion 51 is fixed to the first cover substrate 42. Then, in the other surface side (a lower side in Fig. 6) of the main unit 41, the frame portion 51 is fixed to the second cover substrate 43.

Then, a displacement space 61 is provided between the first cover substrates 42 and a movable portion consisting of the cantilever 52 and the weight portion 53 in the main unit 41, and likewise a displacement space 71 is provided between the second cover substrates 43 and the movable portion, and thereby the movable portion can be displaced.

Incidentally, in the main unit 41 of the power generating having the configuration shown in Fig. 6, the functional portion 54 that comprises the lower electrode 54A, the ferroelectric film 54B and the upper electrode 54C is formed, by using a reactive sputter method or the like, on said one surface side of the silicon substrate 50.

However, typically, a PZT thin film formed by using various thin film formation technologies, such as a sputter method or the like, on one surface side of a silicon substrate has polycrystal. Then, such a PZT thin film has poor quality of crystallinity and also has small piezoelectric constant e₃₁, compared with a monocrystal PZT thin film formed on one surface side of a monocrystal MgO substrate or on one surface side of a monocrystal SrTiO3 substrate being more extremely-expensive than the silicon substrate. Then, various methods for forming a PZT thin film having good crystallinity on one surface side of a monocrystal silicon substrate have been researched and developed at various facilities. However, the reality is that a PZT thin film having sufficient crystallinity has not yet been obtained.

And so, in a ferroelectric device, such as a power generating device, a pyroelectric infrared sensor or the like, that comprises a functional portion having a ferroelectric film on one surface side of a silicon substrate, it has been researched that a buffer layer is provided between a lower electrode and the ferroelectric film for improving the characteristic.

However, when a functional portion that comprises a lower electrode, a ferroelectric film and an upper electrode is formed on one surface side of a silicon substrate and then a region of the silicon substrate corresponding to the functional portion is etched from the other surface side of the silicon substrate to a predetermined depth, thereby forming a cavity in the silicon substrate and manufacturing a ferroelectric device, typically, it is not easy to reproduce the thickness of a thin portion (the cantilever 52 in Fig. 6) in the silicon substrate kept just under the functional portion, and furthermore in a silicon wafer that is an original state of the silicon substrate, there is a lot of variation in a surface of the thin portion. Therefore, the fabrication yield is low and the cost is increased. Further, when the ferroelectric device is a pyroelectric infrared sensor, the device property (the response speed or the like) is reduced due to heat capacity of the thin portion.

So, there is also a suggestion that instead of the silicon substrate, a SOI (silicon on insulator) substrate is used, that is, at the time of manufacture, instead of the silicon wafer, a SOI wafer is used. However, the SOI wafer is more extremely-expensive than the silicon wafer. Therefore, the cost is increased.

### DISCLOSURE OF THE INVENTION

It is an object of the present invention to provide a ferroelectric device, in which the crystallinity and performance of a ferroelectric film can be improved, and in which the device property can be improved at low cost.

A ferroelectric device of the present invention comprises: a silicon substrate; a first electrode formed on one surface side of said silicon substrate; a ferroelectric film formed on a surface of said first electrode opposite to said silicon substrate side; and a second electrode formed on a surface of said ferroelectric film opposite to said first electrode side, wherein said ferroelectric film is formed of a ferroelectric material with a lattice constant difference from silicon, wherein the ferroelectric device further comprises a shock absorbing layer, said shock absorbing layer being formed of a material with better lattice matching with said ferroelectric film than silicon and being provided between said silicon substrate and said first electrode, wherein said silicon substrate is provided with a cavity that exposes a surface of said shock absorbing layer opposite to said first electrode side.

According to this configuration, the crystallinity and performance of a ferroelectric film can be improved, and the device property can be improved at low cost.

In the ferroelectric device, preferably, said first electrode is located on a lower surface side of said ferroelectric film, as a lower electrode, wherein said second electrode is located on an upper surface side of said ferroelectric film, as an upper electrode, wherein said shock absorbing layer is provided directly below said lower electrode, wherein at least a part of a lower surface of said shock absorbing layer is exposed through said cavity of said silicon substrate.

Preferably, the ferroelectric device further comprises a reinforcement layer, and said reinforcement layer is provided on said one surface side of said silicon substrate and is laminated on at least a part of a laminated structure provided with said shock absorbing layer, said lower electrode, said ferroelectric film and said upper electrode, thereby reinforcing the laminated structure.

Preferably, the ferroelectric device further comprises a second shock absorbing layer, in addition to a first shock absorbing layer that is said shock absorbing layer, and said second shock absorbing layer is formed of a material with better lattice matching with said ferroelectric film than said lower electrode and is provided between said ferroelectric film and said lower electrode.

In the ferroelectric device, preferably, said material of said shock absorbing layer is a conductive material.

In the ferroelectric device, preferably, at least one of said material of said first shock absorbing layer and said material of said second shock absorbing layer is a conductive material.

In the ferroelectric device, preferably, said ferroelectric film is a pyroelectric film, wherein said material of said shock absorbing layer has lower thermal conductivity than silicon.

In the ferroelectric device, preferably, said ferroelectric film is a pyroelectric film, wherein said material of said first shock absorbing layer and said material of said second shock absorbing layer have lower thermal conductivity than silicon.

### BRIEF DESCRIPTION OF THE DRAWINGS

Preferred embodiments of the invention will now be described in further details. Other features and advantages of the present invention will become better understood with regard to the following detailed description and accompanying drawings where:
Fig. 1A is a schematic plain view showing a major portion of a ferroelectric device according to a first embodiment of the present invention;
Fig. 1B is a schematic cross-section view taken along line A-A' of Fig. 1A;
Fig. 2 is a schematic cross-section view of the ferroelectric device according to the first embodiment;
Fig. 3 is a schematic exploded perspective view of the ferroelectric device according to the first embodiment;
Fig. 4 is a schematic cross-section view of a ferroelectric device according to a second embodiment of the present invention;
Fig. 5 is a schematic cross-section view of a ferroelectric device according to a third embodiment of the present invention; and
Fig. 6 is a schematic cross-section view of the conventional ferroelectric device.

### BEST MODE FOR CARRYING OUT THE INVENTION

### (First Embodiment)

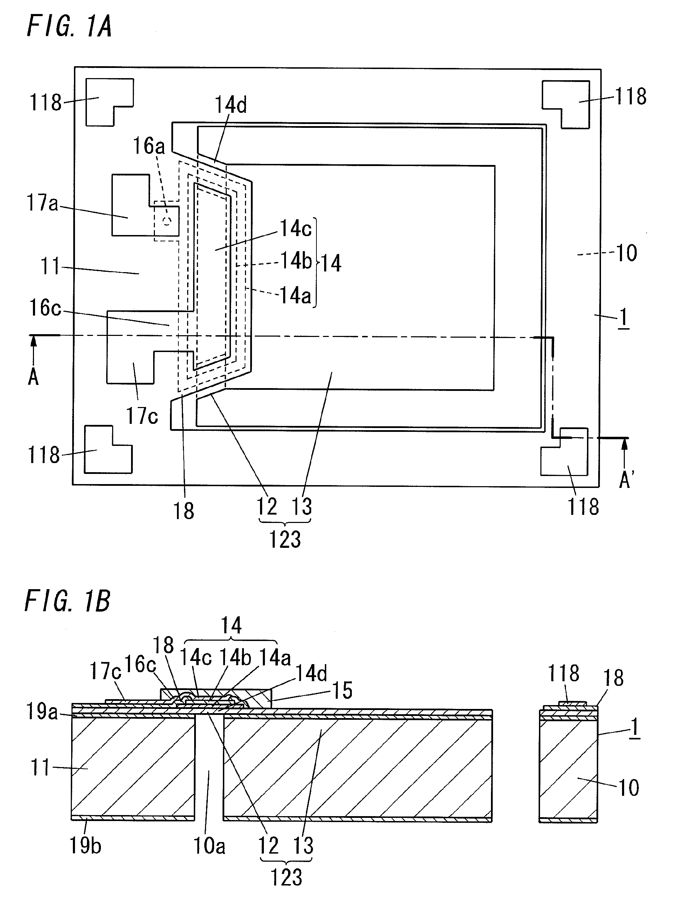

First, a ferroelectric device according to the present embodiment will be explained below referring to Figs. 1A, 1B, 2 and 3.

A main unit 1 of the ferroelectric device comprises: a silicon substrate (hereinafter, called a first silicon substrate) 10; a first electrode 14a formed on one surface side of the first silicon substrate 10; a ferroelectric film 14b formed on a surface of the first electrode 14a opposite to the first silicon substrate 10 side; and a second electrode 14c formed on a surface of the ferroelectric film 14b opposite to the first electrode 14a side. That is, in Fig. 1B, the first electrode 14a is located on a lower surface side of the ferroelectric film 14b, as a lower electrode. The second electrode 14c is located on an upper surface side of the ferroelectric film 14b, as an upper electrode. Hereinafter, the first electrode 14a and the second electrode 14c are called the lower electrode 14a and the upper electrode 14c, respectively. Then, a monocrystal silicon substrate is used as the first silicon substrate 10 and the one surface of the first silicon substrate 10 is formed with a (100) face. The ferroelectric film 14b is formed of a ferroelectric material with a lattice constant difference from silicon.

The ferroelectric device according to the present embodiment is a power generating device that converts vibration energy due to arbitrary vibration, such as automotive vibration, vibration caused by human motion or the like, into electric energy. Then, the ferroelectric film 14b constitutes a piezoelectric membrane.

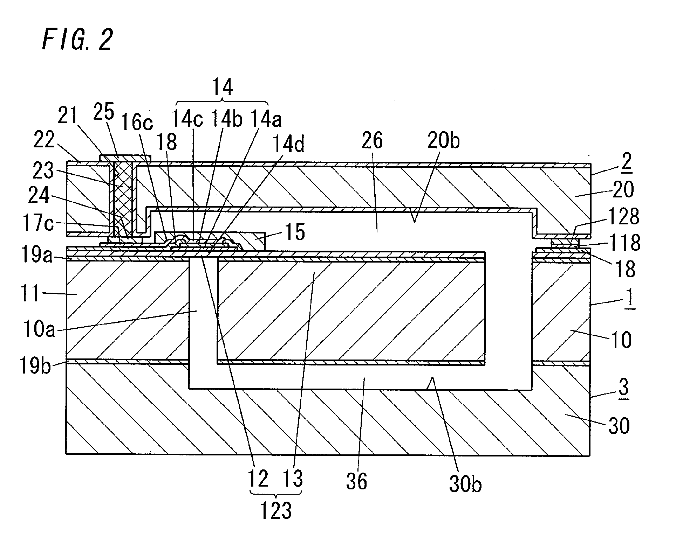

Then, the main unit 1 further comprises a shock absorbing layer 14d. As shown in Figs. 1B and 2, the shock absorbing layer 14d is located between the silicon substrate 10 and the lower electrode 14a (more specifically, is located directly below the lower electrode 14a), and is formed of a material with better lattice matching with the ferroelectric film 14b than silicon. Then, the first silicon substrate 10 is provided with a cavity 10a that exposes a part of a surface of the shock absorbing layer 14d opposite to the lower electrode 14a side (that is, a part of a lower surface of the shock absorbing layer 14d).

In this case, as shown in Figs. 1B and 2, insulation films 19a, 19b (hereinafter, called a first insulation film 19a and a second insulation film 19b) are formed of silicon dioxide films and are provided on the one surface side and the other surface side of the first silicon substrate 10, respectively. The shock absorbing layer 14d is formed on a surface side of the first insulation film 19a that is located in the one surface side of the first silicon substrate 10. Then, the main unit 1 is formed by using micro machining technology or the like, and then, as shown in Fig. 1A, comprises a frame portion 11 that has a frame-shape, and a weight portion 13 that is disposed within the frame portion 11. The weight portion 13 is swingably supported by the frame portion 11 through a cantilever 12 that is disposed on the one surface side of the first silicon substrate 10. Further, a functional portion 14 provided with the abovementioned lower electrode 14a, ferroelectric film 14b and upper electrode 14c is formed on the cantilever 12. Here, in the ferroelectric device according to the present embodiment, the functional portion 14 constitutes a power generating part (a piezoelectric transforming part) that generates an AC voltage in response to vibration of the cantilever 12.

A part of the second insulation film 19b, a part of the first silicon substrate 10, a part of the first insulation film 19a and a part of the shock absorbing layer 14d constitutes the abovementioned frame portion 11 and weight portion 13. The shock absorbing layer 14d constitutes the cantilever 12.

The main unit 1 further includes pads 17a, 17c. In the one surface side of the first silicon substrate 10, the pads 17a, 17c are formed at regions corresponding to the frame portion 11, and are electrically connected to the lower electrode 14a and the upper electrode 14c through metallic wiring 16a, 16c, respectively.

Further, the main unit 1 includes the metallic wiring 16c and an insulation layer 18 that are provided on the one surface side of the first silicon substrate 10. The metallic wiring 16c defines an area in which the upper electrode 14c contacts the ferroelectric film 14b, and is electrically connected to the upper electrode 14c. The insulation layer 18 is formed so as to cover a periphery of the lower electrode 14a and a periphery of the ferroelectric film 14b, thereby preventing short circuit generated between the metallic wiring 16c and the lower electrode 14a. Further, the insulation layer 18 is formed over a wide region of the frame portion 11, and the pads 17a, 17c are formed on the insulation layer 18. The insulation layer 18 is formed of a silicon dioxide film, but is not limited to this configuration. For example, the insulation layer 18 may be formed of a silicon nitride film. Then, the first silicon substrate 10 and the functional portion 14 are electrically insulated from each other through the first insulation film 19a.

As shown in Figs. 1B and 2, the metallic wiring 16c and the upper electrode 14c of the present embodiment are formed of the same one member, but are not limited to this configuration. For example, the metallic wiring 16c and the upper electrode 14c may be formed of different members.

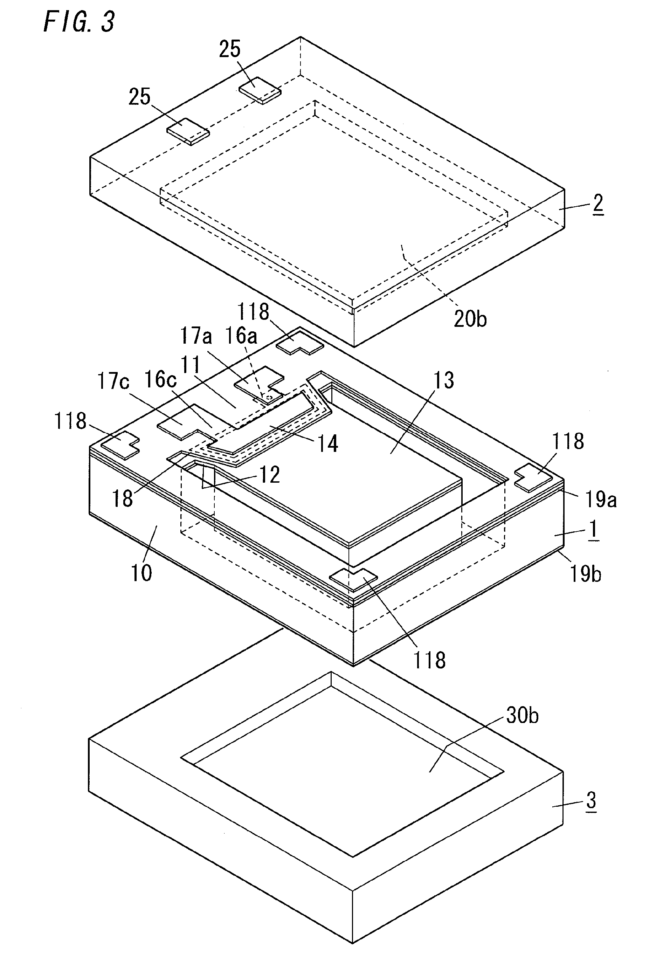

Further, the main unit 1 includes a reinforcement layer 15 that is provided on the one surface side of the first silicon substrate 10. The reinforcement layer 15 is laminated on a laminated structure provided with the shock absorbing layer 14d, the lower electrode 14a, the ferroelectric film 14b and the upper electrode 14c, thereby reinforcing the laminated structure (in Figs. 1A and 3, the graphic display of the reinforcement layer 15 is omitted). The reinforcement layer 15 is formed over a periphery of the functional portion 14, the frame portion 11 and the weight portion 13. Then, for the reinforcement layer 15, preferably, a material that has good matching with so-called semiconductor process is used. For example, the reinforcement layer 15 can be formed of an insulation material including polyimide, fluorine series resin or the like.

Further, the ferroelectric device, as shown in Figs. 2 and 3, includes a first cover substrate 2 that is fixed to the frame portion 11, in one surface side of the main unit 1. Further, the ferroelectric device includes a second cover substrate 3 that is fixed to the frame portion 11, in the other surface side of the main unit 1.

The first cover substrate 2 is formed using a second silicon substrate 20. Then, a recess 20b is formed in one surface of the second silicon substrate 20 facing the main unit 1. Thereby, a displacement space for a movable portion 123 consisting of the cantilever 12 and the weight portion 13 is provided between the second silicon substrate 20 and the main unit 1.

Then, external connection electrodes 25, 25 are formed in the other surface side of the second silicon substrate 20, and are electrically connected to the functional portion 14. Here, the external connection electrodes 25, 25 function as output electrodes for supplying, to the exterior, the AC voltage generated by the power generating part that is the functional portion 14.

The external connection electrodes 25, 25 are electrically connected to access electrodes 24, 24 that are formed on the one surface side of the second silicon substrate 20, through through-hole wirings 23, 23 that penetrate to be installed in a thickness direction of the second silicon substrate 20, respectively. In this case, the access electrodes 24, 24 are bonded to the pads 17a, 17c in the main unit 1, thereby being electrically connected, respectively. In the present embodiment, each of the external connection electrodes 25, 25 and the access electrodes 24, 24 is constituted by a laminated film comprising a Ti film and an Au film. However, these materials are not limited especially. Further, Cu is used as a material of each through-hole wiring 23, but the material is not limited to Cu. For example, Ni, Al or the like may be used as the material.

The first cover substrate 2 is provided with an insulation film 22, thereby preventing short circuit generated between the external connection electrodes 25, 25. The insulation film 22 is formed of a silicon dioxide film, and is provided over the one surface side and the other surface side of the second silicon substrate 20 and inner peripheries of through holes 21 in which the through-hole wirings 23, 23 are provided. Further, the first cover substrate 2 may be formed by using an insulation substrate, such as a glass substrate, stead of the second silicon substrate 20. In this case, the insulation film 22 is not required.

The second cover substrate 3 is formed using a third silicon substrate 30. Then, a recess 30b is formed in one surface of the third silicon substrate 30 facing the main unit 1. Thereby, a displacement space for the movable portion 123 is provided between the third silicon substrate 30 and the main unit 1. Further, the second cover substrate 3 may be formed by using an insulation substrate, such as a glass substrate, stead of the third silicon substrate 30.

Then, a first bonding metal layer 118 for being bonded to the first cover substrate 2 is formed on the one surface side of the first silicon substrate 10. Then, a second bonding metal layer 128 for being bonded to the first bonding metal layer 118 is formed on the one surface side of the second silicon substrate 20 (see Fig. 2). In this case, the same material as the pad 17c is used as a material of the first bonding metal layer 118. The first bonding metal layer 118 is formed on the one surface side of the first silicon substrate 10 so as to have the same thickness as the pad 17c. Further, the first bonding metal layer 118 is formed onto the insulation layer 18.

The main unit 1 is bonded to each of the cover substrates 2, 3 by using a room temperature bonding method. However, the bonding method is not limited to the room temperature bonding method. For example, the main unit 1 may be bonded by using a direct bonding method in which appropriate heating is performed, a resin bonding method using an epoxy resin or the like, or an anodic bonding method. In the resin bonding method, if a room temperature curing type of a resin adhesive (for example, a two-component room temperature curing type of an epoxy resin adhesive, or a one-component room temperature curing type of an epoxy resin adhesive) is used, the bonding temperature can be reduced more than the case where a thermal curing type of a resin adhesive (for example, a thermal curing type of an epoxy resin adhesive or the like) is used.

In the power generating device explained above, the functional portion 14 is constituted by the lower electrode 14a, the ferroelectric film 14b that is a piezoelectric membrane, and the upper electrode 14c. Therefore, the ferroelectric film 14b of the functional portion 14 receives a stress caused by vibration of the cantilever 12, and the bias of electric charge is generated in the upper electrode 14c and the lower electrode 14a, and then an AC voltage is generated in the functional portion 14.

Incidentally, in the ferroelectric device of the present embodiment, PZT that is a type of a lead-based oxide ferroelectric is used as a ferroelectric material of the ferroelectric film 14b, and further, a monocrystal silicon substrate is used as the first silicon substrate 10 and the one surface of the first silicon substrate 10 is formed with a (100) face. In this case, the lead-based oxide ferroelectric is not limited to PZT. For example, PZT-PMN (:Pb(Mn,Nb)O3) or PZT including other impurities may be adopted. In any case, the ferroelectric material of the ferroelectric film 14b is a ferroelectric material (the lead-based oxide ferroelectric, such as PZT, PZT-PMN or PZT including other impurities) with a lattice constant difference from silicon.

Further, in the present embodiment, Pt is used as the material of the lower electrode 14a, and Au is used as the material of the upper electrode 14c. However, these materials are not limited especially. For example, Au, Al or Ir may be used as the material of the lower electrode 14a, and Mo, Al or Pt may be used as the material of the upper electrode 14c.

Then, as the material of the shock absorbing layer 14d, SrRuO3 is used, but the material is not limited to this. For example, (Pb,La)TiO3, PbTiO3, MgO, LaNiO3 or the like may be used. Further, for example, the shock absorbing layer 14d may be constituted by a laminated film that comprises a Pt film and a SrRuO3 film.

In the ferroelectric device (power generating device) of the present embodiment, the shock absorbing layer 14d has a thickness of 2µm, and the lower electrode 14a has a thickness of 500nm, and the ferroelectric film 14b has a thickness of 600nm, and the upper electrode 14c has a thickness of 100nm. However, these numerical values are one example, and are not limited especially. Then, when a relative permittivity of the ferroelectric film 14b is denoted by "e" and a power generating index is denoted by "P", P is proportional to e₃₁^{2/ε}, where "e₃₁" is a piezoelectric constant of the ferroelectric film 14b. The power generation efficiency increases with increase in the power generating index P.

Hereinafter, a method for manufacturing a power generating device being the ferroelectric device of the present embodiment will be explained simply.

First, by using a thermal oxidation method, the insulation films 19a of a silicon dioxide film is formed on the entire surface of the one surface side of the first silicon substrate 10, and the insulation films 19b of a silicon dioxide film is formed on the entire surface of the other surface side of the first silicon substrate 10. Then, the shock absorbing layer 14d is deposited on the entire surface of the one surface side of the first silicon substrate 10 (in this case, onto the first insulation film 19a), by using a sputtering method, a CVD method, an evaporation method or the like. Then, the lower electrode 14a is deposited on the entire surface of the shock absorbing layer 14d opposite to the first silicon substrate 10 side, by using a sputtering method, a CVD method, an evaporation method or the like. Then, the ferroelectric film 14b is deposited on the entire surface of the lower electrode 14a opposite to the shock absorbing layer 14d side, by using a sputtering method, a CVD method, a sol-gel method or the like.

After the deposition of the ferroelectric film 14b, patterning of the ferroelectric film 14b is performed by using photolithography technology and etching technology, and then, patterning of the lower electrode 14a is performed by using photolithography technology and etching technology. As a result, a part of the lower electrode 14a is formed into a predetermined shape through the patterning, and the remaining part of the electrode 14a is kept in the same status as before the patterning, as the metallic wiring 16a. The part of the lower electrode 14a to which the patterning was performed and the metallic wiring 16a can be also considered as one lower electrode 14a.

After the formation of the metallic wiring 16a, the insulation layer 18 is formed into a predetermined shape on the one surface side of the first silicon substrate 10. Then, the upper electrode 14c, the metallic wiring 16c, the pads 17a, 17c and the first bonding metal layer 118 are formed by using thin-film formation technology such as a sputtering method or CVD method, photolithography technology and etching technology. Then, the reinforcement layer 15 of a polyimide layer is formed. In the formation of the predetermined-shaped insulation layer 18, the insulation layer 18 is deposited on the entire surface of the one surface side of the first silicon substrate 10 by using a CVD method, and then patterning of the layer 18 is performed by using photolithography technology and etching technology. However, the insulation layer 18 may be formed by using lift-off technology. Further, in the formation of the reinforcement layer 15, when for example photosensitive polyimide is used as the material of the reinforcement layer 15, coating, photographic exposure, development, curing and the like of polyimide may be performed sequentially. The material and formation method of the reinforcement layer 15 are one example, and are not limited especially.

After the formation of the reinforcement layer 15, the first silicon substrate 10 and the insulation films 19a, 19b are processed by using photolithography technology and etching technology, and thereby the frame portion 11, the cantilever 12 and the weight portion 13 are formed and the main unit 1 is formed. In the process, the first silicon substrate 10 is etched from the other surface side, through the reactive ion etching using SF6 gas or the like as the etching gas, and then the selective etching that uses the first insulation film 19a as an etching stopper layer is performed. Next, the first insulation film 19a is etched from the other surface side of the first silicon substrate 10, through the reactive and anisotropic etching using fluorine series gas, chlorine-based gas or the like as the etching gas, and then the selective etching that uses the shock absorbing layer 14d as an etching stopper layer is performed. Then, the shock absorbing layer 14d is etched through the mechanical etching (the sputter etching) that uses only argon gas as the etching gas, in regard to the etching of unwanted parts of the layer 14d.

After the formation of the main unit 1, the cover substrates 2, 3 are bonded to the main unit 1, thereby obtaining the ferroelectric device having the configuration shown in Fig. 2. Here, the manufacturing is performed at the wafer level until the bonding process of the cover substrates 2, 3 to the main unit 1 is completed (that is, a silicon wafer is used about each of the silicon substrates 10, 20 and 30), and after that, the dicing process is performed, thereby dividing to each ferroelectric device. The cover substrates 2, 3 bonded to the main unit 1 may be formed by using appropriately widely know process, such as a photolithography process, an etching process, a thin-film formation process or a plating process. The cover substrates 2, 3 in the ferroelectric device are not indispensable. The ferroelectric device may be provided with only one of the cover substrates 2, 3, or may be provided with none of the cover substrates 2, 3.

In the method for manufacturing the ferroelectric device explained above, when the cavity 10a is formed, the shock absorbing layer 14d can be used as an etching stopper layer. Then, a part of the shock absorbing layer 14d that is exposed through the cavity 10a can directly become the cantilever 12 (a thin portion). Accordingly, with respect to a portion (in this case, the shock absorbing layer 14d) formed directly below the functional portion 14 including the lower electrode 14a, the ferroelectric film 14b and the upper electrode 14c, the reproducibility of the thickness can be improved without using a SOI substrate that is more extremely-expensive than the first silicon substrate 10. Furthermore, with respect to the portion (in this case, the shock absorbing layer 14d) formed directly below the functional portion 14, the thickness variation can be reduced in a surface of one silicon wafer in which a plurality of main units 1 are formed. That is, when the cavity 10a is formed, the selective etching that uses the shock absorbing layer 14d as an etching stopper layer is eventually performed. Accordingly, the thickness variation within a surface of the portion formed directly below the functional portion 14 is almost determined by the thickness variation within a surface of the shock absorbing layer 14d when the layer 14d is deposited.

As explained above, the ferroelectric device of the present embodiment comprises: the silicon substrate 10; the lower electrode 14a formed on the one surface side of the first silicon substrate 10; the ferroelectric film 14b formed on a surface of the lower electrode 14a opposite to the first silicon substrate 10 side; and the upper electrode 14c formed on a surface of the ferroelectric film 14b opposite to the lower electrode 14a side. The ferroelectric film 14b is formed of a ferroelectric material with a lattice constant difference from silicon. The ferroelectric device further comprises a shock absorbing layer 14d formed of a material with better lattice matching with the ferroelectric film 14b than silicon and provided directly below the lower electrode 14a. The silicon substrate 10 is provided with a cavity 10a that exposes a surface of the shock absorbing layer 14d opposite to the lower electrode 14a side. Therefore, when the cavity 10a is formed, the shock absorbing layer 14d can be used as an etching stopper layer. And then, a part of the shock absorbing layer 14d that is exposed through the cavity 10a can directly become the cantilever 12 (a thin portion). Accordingly, the crystallinity and the performance (in this case, piezoelectric constant e₃₁) of the ferroelectric film 14b can be improved, and the power generating property (the power generation efficiency or the like) that is the device property can be improved at low cost.

Then, the ferroelectric device of the present embodiment comprises a reinforcement layer 15 provided on the one surface side of the first silicon substrate 10. The reinforcement layer 15 is laminated on at least a part of a laminated structure provided with the shock absorbing layer 14d, the lower electrode 14a, the ferroelectric film 14b and the upper electrode 14c, thereby reinforcing the laminated structure. Therefore, the ferroelectric device can prevent each of the shock absorbing layer 14d, the lower electrode 14a, the ferroelectric film 14b and the upper electrode 14c from being damaged or cracked by vibration. Especially, in the power generating device that is the ferroelectric device of the present embodiment, the cantilever 12 constituted by a part of the shock absorbing layer 14d can be prevented from being damaged, and reliability can be increased.

In the ferroelectric device of the present embodiment, a conductive material, such as SrRuO3, is used as the material of the shock absorbing layer 14d. Therefore, the ferroelectric device can efficiently take out an electric field generated by twist when the cantilever 12 vibrates, and the power generating property that is the device property can be improved.

Further, when an insulating material is adopted as the material of the shock absorbing layer 14d, the abovementioned first insulation film 19a is not indispensable. In this case, when the first silicon substrate 10 is etched from the other surface side, the selective etching that uses the shock absorbing layer 14d as an etching stopper layer may be performed. Also, when a conductive material is adopted as the material of the shock absorbing layer 14d, and the lower electrode 14a is permitted to have the same electric potential as the first silicon substrate 10, the first insulation film 19a is not required. Also, when a plurality of functional portions 14 are provided on the one surface side of one first silicon substrate 10 and a plurality of lower electrodes 14a of the functional portions 14 are configured so as to have the same electric potential as each other, the first insulation film 19a is not required.

### (Second Embodiment)

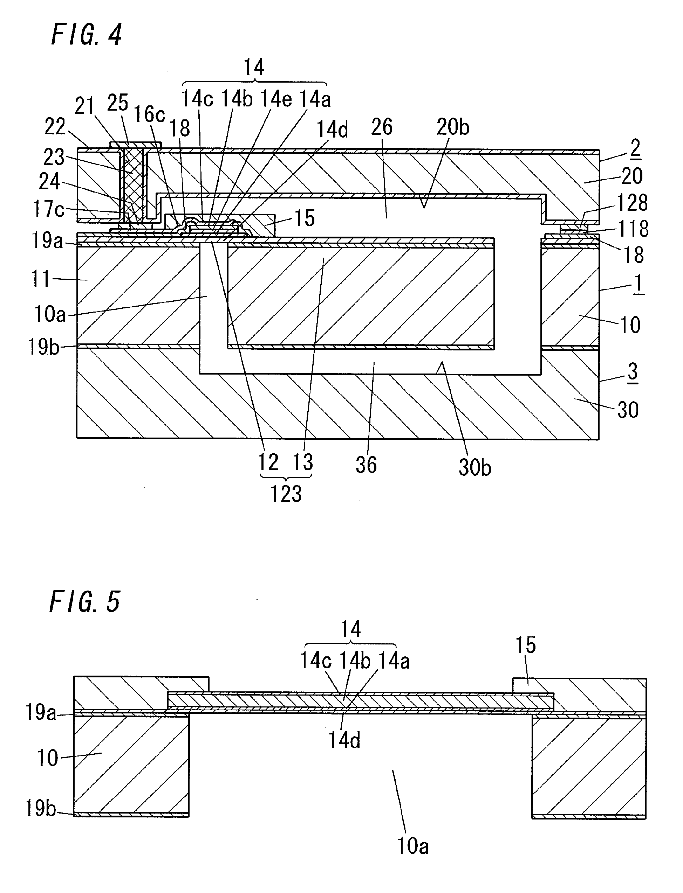

The basic configuration of a ferroelectric device of the present embodiment is substantially identical to that of the First Embodiment. As shown Fig. 4, the difference therebetween is that a second shock absorbing layer 14e is provided between the ferroelectric film 14b and the lower electrode 14a, in addition to the shock absorbing layer 14d (hereinafter, called a first shock absorbing layer) provided directly below the lower electrode 14a. The second shock absorbing layer 14e is formed of a material with better lattice matching with the ferroelectric film 14b than the lower electrode 14a. Then, the constituent elements same as those of the First Embodiment are assigned with same reference numerals and the explanation thereof is herein omitted.

A method for manufacturing the ferroelectric device of the present embodiment is substantially identical to that explained in the First Embodiment. The difference therebetween is that the lower electrode 14a is formed on the entire surface of the one surface side of the silicon substrate 10, and the second shock absorbing layer 14e is then formed on the entire surface of the one surface side of the silicon substrate 10, and the ferroelectric film 14b is then formed on the entire surface of the one surface side of the silicon substrate 10. The material of the second shock absorbing layer 14e may be identical to or different from that of the first shock absorbing layer 14d. However, it is preferred that at least the second shock absorbing layer 14e is a conductive material.

The ferroelectric device of the present embodiment further comprises the second shock absorbing layer 14e provided directly below the ferroelectric film 14b. Therefore, the ferroelectric device of the present embodiment can improve the crystallinity of the ferroelectric film 14b more than that of the First Embodiment.

### (Third Embodiment)

A ferroelectric device according to the present embodiment will be explained below referring to Fig. 5.

A ferroelectric device of the present embodiment comprises: a silicon substrate 10; a lower electrode 14a formed on one surface side of the silicon substrate 10; a ferroelectric film 14b formed on a surface of the lower electrode 14a opposite to the silicon substrate 10 side; and an upper electrode 14c formed on a surface of the ferroelectric film 14b opposite to the lower electrode 14a side. In this case, a monocrystal silicon substrate is used as the silicon substrate 10 and the one surface of the silicon substrate 10 is formed with a (100) face. The ferroelectric film 14b is formed of a ferroelectric material with a lattice constant difference from Si. Then, in the ferroelectric device, the constituent elements same as those of the First Embodiment are assigned with same reference numerals.

The ferroelectric device of the present embodiment is a pyroelectric infrared sensor, and the ferroelectric film 14b constitutes a pyroelectric film.

Further, a shock absorbing layer 14d is provided directly below the lower electrode 14a and is formed of a material with better lattice matching with the ferroelectric film 14b than silicon. The silicon substrate 10 is provided with a cavity 10a that exposes a part of a surface of the shock absorbing layer 14d opposite to the lower electrode 14a side.

In this case, insulation films 19a, 19b (hereinafter, called a first insulation film 19a and a second insulation film 19b) are formed of silicon dioxide films and are provided on the one surface side and the other surface side of the silicon substrate 10, respectively. The shock absorbing layer 14d is formed on a surface side of the first insulation film 19a which is located in the one surface side of the silicon substrate 10.

In the ferroelectric device of the present embodiment, PZT that is a type of a lead-based oxide ferroelectric is used as a ferroelectric material (a pyroelectric material) of the ferroelectric film 14b. However, the lead-based oxide ferroelectric is not limited to PZT. For example, PZT-PLT, PLT, PZT-PMN or PZT-based ferroelectric including other impurities may be adopted. In any case, the pyroelectric material of the ferroelectric film 14b is a ferroelectric material (the lead-based oxide ferroelectric, such as PZT, PZT-PMN or PZT including other impurities) with a lattice constant difference from silicon that is a material of the silicon substrate 10. On the other hand, as the material of the shock absorbing layer 14d, SrRuO3 is used, but the material is not limited to this. For example, (Pb,La)TiO3, PbTiO3, MgO, LaNiO3 or the like may be used. Further, for example, the shock absorbing layer 14d may be constituted by a laminated film that comprises a Pt film and a SrRuO3 film.

Further, in the present embodiment, Pt is used as the material of the lower electrode 14a. An infrared absorbing material having the conductive property, such as Ni-Cr, Ni or Au-black, is used as the material of the upper electrode 14c. Then, a functional portion 14, being a sensing element, is constituted by the lower electrode 14a, the pyroelectric thin film 14b and the upper electrode 14c. However, these materials are not limited especially. For example, Au, Al or Cu may be used as the material of the lower electrode 14a. In this case, when the abovementioned infrared absorbing material having the conductive property is used as the material of the upper electrode 14c, the upper electrode 14c doubles as an infrared absorbing film. Further, in the present embodiment, the cavity 10a constitutes a cavity for obtaining heat insulation between the functional portion 14 and the silicon substrate 10.

Further, the ferroelectric device includes a reinforcement layer 15 that is provided on the one surface side of the silicon substrate 10. The reinforcement layer 15 is laminated on a laminated structure provided with the shock absorbing layer 14d, the lower electrode 14a, the ferroelectric film 14b and the upper electrode 14c, thereby reinforcing the laminated structure. The reinforcement layer 15 is formed over a periphery of the functional portion 14 and the one surface of the silicon substrate 10 around the cavity 10a. Then, for the reinforcement layer 15, preferably, a material that has good matching with so-called semiconductor process is used. For example, the reinforcement layer 15 can be also formed of an insulation material including polyimide, fluorine series resin or the like.

Incidentally, in the pyroelectric infrared sensor like the ferroelectric device of the present embodiment, the enhancement of the heat insulation property between the functional portion 14 and the silicon substrate 10 is required in order to improve the sensor property. Therefore, it is preferred that the material of the shock absorbing layer 14d has lower thermal conductivity than silicon. It is known that the thermal conductivity of silicon is about 145-156 W/m.K. On the other hand, it is known that the thermal conductivity of SrRuO3 is about 5.97 W/m.K.

In addition, in the pyroelectric device of the present embodiment, the shock absorbing layer 14d has a thickness of 1µm-2µm, and the lower electrode 24a has a thickness of 100nm, and the ferroelectric film 24b has a thickness of 1µm-3µm, and the upper electrode 24c has a thickness of 50nm. However, these numerical values are one example, and are not limited especially.

The ferroelectric device of the present embodiment is the pyroelectric infrared sensor, as explained above. Then, when a pyroelectric coefficient of the ferroelectric film 14b is denoted by γ[C/(cm²·K)], an electric permittivity is denoted by "ε" and an performance index of the pyroelectric infrared sensor (the pyroelectric device) is denoted by Fγ[C/(cm²·J)], Fγ is proportional to γ/ε. Therefore, the performance index Fγ increases with increase in the pyroelectric coefficient γ of the ferroelectric film 14b.

Hereinafter, a method for manufacturing the pyroelectric infrared sensor being the ferroelectric device of the present embodiment will be explained. However, in regard to the processes same as those in the method for manufacturing the ferroelectric device explained in the First Embodiment, the explanation thereof will be omitted appropriately.

First, by using a thermal oxidation method, the insulation films 19a of a silicon dioxide film is formed on the entire surface of the one surface side of the silicon substrate 10 and the insulation films 19b of a silicon dioxide film is formed on the entire surface of the other surface side of the silicon substrate 10. Then, the shock absorbing layer 14d is deposited on the entire surface of the one surface side of the silicon substrate 10 (in this case, onto the first insulation film 19a), by using a sputtering method, a CVD method, an evaporation method or the like. Then, the lower electrode 14a is deposited on the entire surface of the shock absorbing layer 14d opposite to the silicon substrate 10 side, by using a sputtering method, a CVD method, an evaporation method or the like. Then, the ferroelectric film 14b is deposited on the entire surface of the lower electrode 14a opposite to the shock absorbing layer 14d side, by using a sputtering method, a CVD method, a sol-gel method or the like.

After the deposition of the ferroelectric film 14b, patterning of the ferroelectric film 14b is performed by using photolithography technology and etching technology, and then, patterning of the lower electrode 14a is performed by using photolithography technology and etching technology.

Then, the upper electrode 14c is formed into a predetermined shape on the one surface side of the silicon substrate 10, by using thin-film formation technology, such as a sputtering method or a CVD method, photolithography technology and etching technology. Then, the reinforcement layer 15 of a polyimide layer is formed. In the formation of the reinforcement layer 15, when for example photosensitive polyimide is used as the material of the reinforcement layer 15, coating, photographic exposure, development, curing and the like of polyimide may be performed sequentially. The abovementioned material and formation method of the reinforcement layer 15 are one example, and are not limited especially.

After the above formation of the reinforcement layer 15, the silicon substrate 10 and the insulation films 19a, 19b are processed by using photolithography technology and etching technology, and thereby the cavity 10a is formed. In the process, the silicon substrate 10 is etched from the other surface side, through the reactive ion etching using SF6 gas or the like as the etching gas, and then the selective etching that uses the first insulation film 19a as an etching stopper layer is performed. Next, the first insulation film 19a is etched from the other surface side of the silicon substrate 10, through the reactive and anisotropic etching using fluorine series gas, chlorine-based gas or the like as the etching gas, and then the selective etching that uses the shock absorbing layer 14d as an etching stopper layer is performed.

Here, the manufacturing is performed at the wafer level until the formation process of the cavity 10a is completed, and after that (that is, after a plurality of ferroelectric devices are formed in a silicon wafer), the dicing process is performed, thereby dividing to each ferroelectric device.

In the method for manufacturing the ferroelectric device explained above, when the cavity 10a is formed, the shock absorbing layer 14d can be used as an etching stopper layer. Accordingly, with respect to a portion (in this case, the shock absorbing layer 14d) formed directly below the functional portion 14 including the lower electrode 14a, the ferroelectric film 14b and the upper electrode 14c, the reproducibility of the thickness can be improved without using a SOI substrate that is more extremely-expensive than the silicon substrate 10. Furthermore, with respect to the portion (in this case, only the shock absorbing layer 14d) formed directly below the functional portion 14, the thickness variation can be reduced in a surface of one silicon wafer in which a plurality of pyroelectric infrared sensors are formed. That is, when the cavity 10a is formed, the selective etching that uses the shock absorbing layer 14d as an etching stopper layer is eventually performed. Accordingly, the thickness variation within a surface of the portion formed directly below the functional portion 14 is almost determined by the thickness variation within a surface of the shock absorbing layer 14d when the layer 14d is deposited.

As explained above, the ferroelectric device of the present embodiment comprises: the silicon substrate 10; the lower electrode 14a formed on the one surface side of the silicon substrate 10; the ferroelectric film 14b formed on a surface of the lower electrode 14a opposite to the silicon substrate 10 side; and the upper electrode 14c formed on a surface of the ferroelectric film 14b opposite to the lower electrode 14a side. The ferroelectric film 14b is formed of a ferroelectric material with a lattice constant difference from silicon. The ferroelectric device further comprises the shock absorbing layer 14d formed of a material with better lattice matching with the ferroelectric film 14b than silicon and provided directly below the lower electrode 14a. The silicon substrate 10 is provided with the cavity 10a exposing a surface of the shock absorbing layer 14d opposite to the lower electrode 14a side. Therefore, when the cavity 10a is formed, the shock absorbing layer 14d can be used as an etching stopper layer. Accordingly, the crystallinity and the performance (in this case, the pyroelectric coefficient γ) of the ferroelectric film 14b can be improved, and the device property (in this case, the performance index and the response speed) can be improved at low cost.

Then, the ferroelectric device of the present embodiment further comprises the reinforcement layer 15 provided on the one surface side of the silicon substrate 10. The reinforcement layer 15 is laminated on at least a part of a laminated structure provided with the shock absorbing layer 14d, the lower electrode 14a, the ferroelectric film 14b and the upper electrode 14c, thereby reinforcing the laminated structure. Therefore, the ferroelectric device can prevent each of the shock absorbing layer 14d, the lower electrode 14a, the ferroelectric film 14b and the upper electrode 14c from being damaged or cracked by vibration.

Further, in the ferroelectric device of the present embodiment, a conductive material, such as SrRuO3, is used as the material of the shock absorbing layer 14d. Therefore, the device property can be improved.

Further, when an insulating material is adopted as the material of the shock absorbing layer 14d, the abovementioned first insulation film 19a is not indispensable. In this case, when the silicon substrate 10 is etched from the other surface side, the selective etching that uses the shock absorbing layer 14d as an etching stopper layer may be performed. Also, when a conductive material is adopted as the material of the shock absorbing layer 14d and the lower electrode 14a is permitted to have the same electric potential as the silicon substrate 10, the first insulation film 19a is not required. Also, when a plurality of functional portions 14 are provided on the one surface side of one silicon substrate 10 and a plurality of lower electrodes 14a of the functional portions 14 are configured so as to have the same electric potential as each other, the first insulation film 19a is not required.

The ferroelectric device having the configuration shown in the above mentioned Fig. 5 is a pyroelectric infrared sensor including one functional portion 14, being a sensing element. However, the device is not limited to such a pyroelectric infrared sensor. For example, the device may be a pyroelectric infrared sensor in which a plurality of functional portions 14 are arranged in two-dimensional array.

Further, in the ferroelectric device of the present embodiment, a second shock absorbing layer 14e may be provided between the ferroelectric film 14b and the lower electrode 14a, in addition to the shock absorbing layer 14d (a first shock absorbing layer) provided directly below the lower electrode 14a, as is the case with the Second Embodiment. In this case, the second shock absorbing layer 14e is formed of a material with better lattice matching with the ferroelectric film 14b than the lower electrode 14a.

Although the present invention has been described with reference to certain preferred embodiments, numerous modifications and variations can be made by those skilled in the art without departing from the true spirit and scope of this invention, namely claims.

## Claims

1. A ferroelectric device, comprising:
a silicon substrate;
a first electrode formed on one surface side of said silicon substrate;
a ferroelectric film formed on a surface of said first electrode opposite to said silicon substrate side; and
a second electrode formed on a surface of said ferroelectric film opposite to said first electrode side,
wherein said ferroelectric film is formed of a ferroelectric material with a lattice constant difference from silicon,
wherein the ferroelectric device further comprises a shock absorbing layer, said shock absorbing layer being formed of a material with better lattice matching with said ferroelectric film than silicon and being provided between said silicon substrate and said first electrode,
wherein said silicon substrate is provided with a cavity that exposes a surface of said shock absorbing layer opposite to said first electrode side.

2. The ferroelectric device according to claim 1,
wherein said first electrode is located on a lower surface side of said ferroelectric film, as a lower electrode,
wherein said second electrode is located on an upper surface side of said ferroelectric film, as an upper electrode,
wherein said shock absorbing layer is provided directly below said lower electrode,
wherein at least a part of a lower surface of said shock absorbing layer is exposed through said cavity of said silicon substrate.

3. The ferroelectric device according to claim 2, further comprises a reinforcement layer, said reinforcement layer being provided on said one surface side of said silicon substrate, and being laminated on at least a part of a laminated structure provided with said shock absorbing layer, said lower electrode, said ferroelectric film and said upper electrode, thereby reinforcing the laminated structure.

4. The ferroelectric device according to claim 2, further comprises a second shock absorbing layer, in addition to a first shock absorbing layer that is said shock absorbing layer, said second shock absorbing layer being formed of a material with better lattice matching with said ferroelectric film than said lower electrode and being provided between said ferroelectric film and said lower electrode.

5. The ferroelectric device according to any one of claims 1 to 3,
wherein said material of said shock absorbing layer is a conductive material.

6. The ferroelectric device according to claim 4,
wherein at least one of said material of said first shock absorbing layer and said material of said second shock absorbing layer is a conductive material.

7. The ferroelectric device according to any one of claims 1 to 3,
wherein said ferroelectric film is a pyroelectric film,
wherein said material of said shock absorbing layer has lower thermal conductivity than silicon.

8. The ferroelectric device according to claim 5,
wherein said ferroelectric film is a pyroelectric film,
wherein said material of said shock absorbing layer has lower thermal conductivity than silicon.

9. The ferroelectric device according to claim 4 or 6,
wherein said ferroelectric film is a pyroelectric film,
wherein said material of said first shock absorbing layer and said material of said second shock absorbing layer have lower thermal conductivity than silicon.
